(19) **Europäisches Patentamt / European Patent Office / Office européen des brevets**

(11) **EP 4 310 779 A1**

(12) # EUROPEAN PATENT APPLICATION

(43) Date of publication:
**24.01.2024 Bulletin 2024/04**

(21) Application number: **22306072.4**

(22) Date of filing: **19.07.2022**

(51) International Patent Classification (IPC):
**G06T 7/11** *(2017.01)*       **G06T 7/162** *(2017.01)*
**G06T 17/20** *(2006.01)*

(52) Cooperative Patent Classification (CPC):
**G06T 7/11; G06T 7/162; G06T 17/20; G06T 19/00;**
G06F 30/00; G06T 2207/20081; G06T 2207/20084

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **Dassault Systèmes**
**78140 Vélizy-Villacoublay (FR)**

(72) Inventors:
- **REJEB SFAR, Asma**
  **78140 Vélizy-Villacoublay (FR)**
- **CHARDONNET, Markus**
  **78140 Vélizy-Villacoublay (FR)**

(74) Representative: **Bandpay & Greuter**
**30, rue Notre-Dame des Victoires**
**75002 Paris (FR)**

(54) **SEGMENTING A BUILDING SCENE**

(57)     The disclosure notably relates to a computer-implemented method for segmenting a building scene. The method comprises providing a training dataset of top-down depth maps. Each depth map comprises labeled line segments and junctions between line segments. The method further comprises learning, based on the training dataset, a neural network. The neural network is configured to take as input a top-down depth map of a building scene comprising building partitions and to output a scene wireframe including the partitions and junctions between the partitions. This constitutes an improved solution for scene segmentation.

FIG. 27

EP 4 310 779 A1

## Description

## TECHNICAL FIELD

The disclosure relates to the field of computer programs and systems, and more specifically to a method, system and program for segmenting a building scene.

## BACKGROUND

A number of systems and programs are offered on the market for the design, the engineering and the manufacturing of objects. CAD is an acronym for Computer-Aided Design, e.g. it relates to software solutions for designing an object. CAE is an acronym for Computer-Aided Engineering, e.g. it relates to software solutions for simulating the physical behavior of a future product. CAM is an acronym for Computer-Aided Manufacturing, e.g. it relates to software solutions for defining manufacturing processes and operations. In such computer-aided design systems, the graphical user interface plays an important role as regards the efficiency of the technique. These techniques may be embedded within Product Lifecycle Management (PLM) systems. PLM refers to a business strategy that helps companies to share product data, apply common processes, and leverage corporate knowledge for the development of products from conception to the end of their life, across the concept of extended enterprise. The PLM solutions provided by Dassault Systemes (under the trademarks CATIA, ENOVIA and DELMIA) provide an Engineering Hub, which organizes product engineering knowledge, a Manufacturing Hub, which manages manufacturing engineering knowledge, and an Enterprise Hub which enables enterprise integrations and connections into both the Engineering and Manufacturing Hubs. All together the system delivers an open object model linking products, processes, resources to enable dynamic, knowledge-based product creation and decision support that drives optimized product definition, manufacturing preparation, production and service.

Within this context and other contexts, scene segmentation is gaining wide importance. There is however still a need for improved solutions for scene segmentation.

## SUMMARY

It is therefore provided a computer-implemented method for segmenting a building scene. The method comprises providing a training dataset of top-down depth maps. Each depth map comprises labeled line segments and junctions between line segments. The method further comprises learning, based on the training dataset, a neural network. The neural network is configured to take as input a top-down depth map of a building scene comprising building partitions and to output a scene wireframe including the partitions and junctions between the partitions.

The method may comprise one or more of the following:

- each top-down depth map of the training dataset comprises:

  ○ random points, and
  ○ line segments each between a respective pair of points, the line segments having random heights;

- one or more top-down depth maps of the training dataset comprise one or more distractors, a distractor being any other object than a line segment; and/or
- one or more of the top-down depth maps comprise noise.

It is further provided a neural network learnable according to the method (e.g. having been learnt by the method). The neural network is a computer-implemented data structure (e.g. stored on a computer medium, such as a non-transitory computer-medium) of layers of neurons with weights. The weight values are equal to weight values set by the learning according to the method, e.g. the weight values have been set by the learning according to the method.

It is further provided a method of use of the neural network. The method of use comprises providing a top-down depth map of a building scene comprising building partitions. The method of use further comprises obtaining, by applying the neural network to the provided top-down depth map, a wireframe of the building scene. The wireframe includes the partitions and junctions between the partitions.

The method of use may comprise one or more of the following:

- the method further comprises computing 2D regions of the provided depth map by extracting, from the obtained wireframe, 2D regions of which contours are formed by line segments of the obtained wireframe;
- computing the 2D regions comprises

  ○ providing a graph comprising:

    ■ graph nodes each representing a junction, and
    ■ graph edges each representing a line segment between two junctions represented two graph nodes, each graph edge comprising two half-edges having opposite orientations; and

  ○ determining, using the half-edges:

    ■ regions of the graph delimited by graph edges and not crossed by any graph edge, and
- overall edge contours of the graph;

- computing the 2D regions further comprises:

  ○ computing, using the Shoelace formula, the areas of each determined region of the graph and overall edge contour of the graph; and
  ○ discarding, using the computed areas:

    - regions having a negative area,
    - regions having an area lower than a predefined threshold, and
    - regions having a width lower than a predefined threshold;

- the provided depth map stems from a 3D point cloud, and the method further comprises:
  ○ projecting the computed 2D regions on the 3D point cloud, thereby obtaining a 3D segmentation of the building scene;
- the provided depth map and/or the 3D point cloud stems from physical measurements; and/or
- the method further comprises filtering the obtained wireframe by discarding partitions and/or junctions not satisfying a neural network prediction confidence score criterion and/or satisfying a smallness criterion.

It is further provided a computer program comprising instructions for performing the method and/or a method of use.

It is further provided a computer readable storage medium having recorded thereon the computer program and/or the neural network.

It is further provided a system comprising a processor coupled to a memory, the memory having recorded thereon the computer program and/or the neural network.

It is further provided a device comprising a data storage medium having recorded thereon the computer program and/or the neural network.

The device may form or serve as a non-transitory computer-readable medium, for example on a SaaS (Software as a service) or other server, or a cloud based platform, or the like. The device may alternatively comprise a processor coupled to the data storage medium. The device may thus form a computer system in whole or in part (e.g. the device is a subsystem of the overall system). The system may further comprise a graphical user interface coupled to the processor.

## BRIEF DESCRIPTION OF THE DRAWINGS

Non-limiting examples will now be described in reference to the accompanying drawings, where:

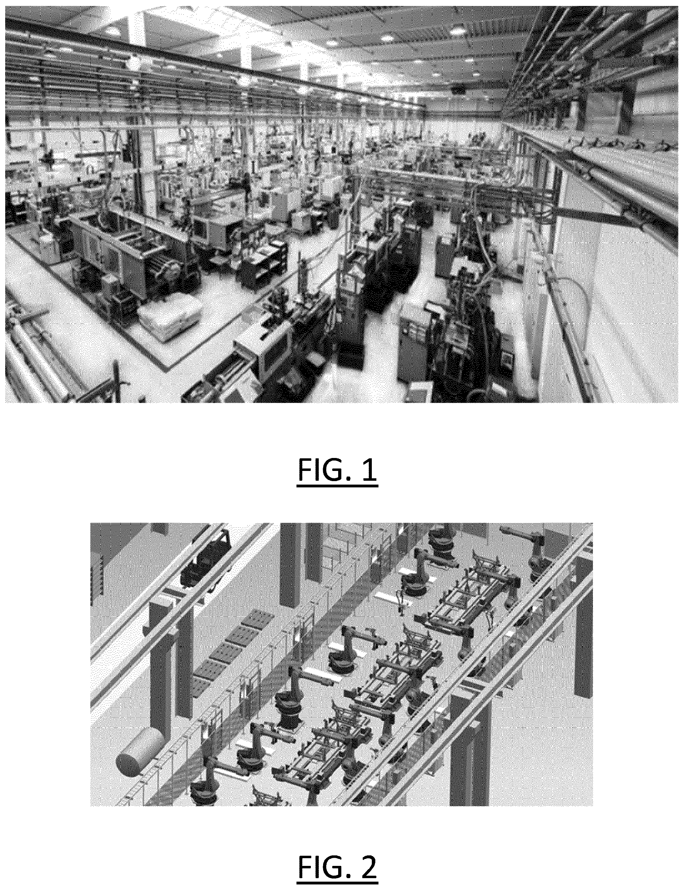

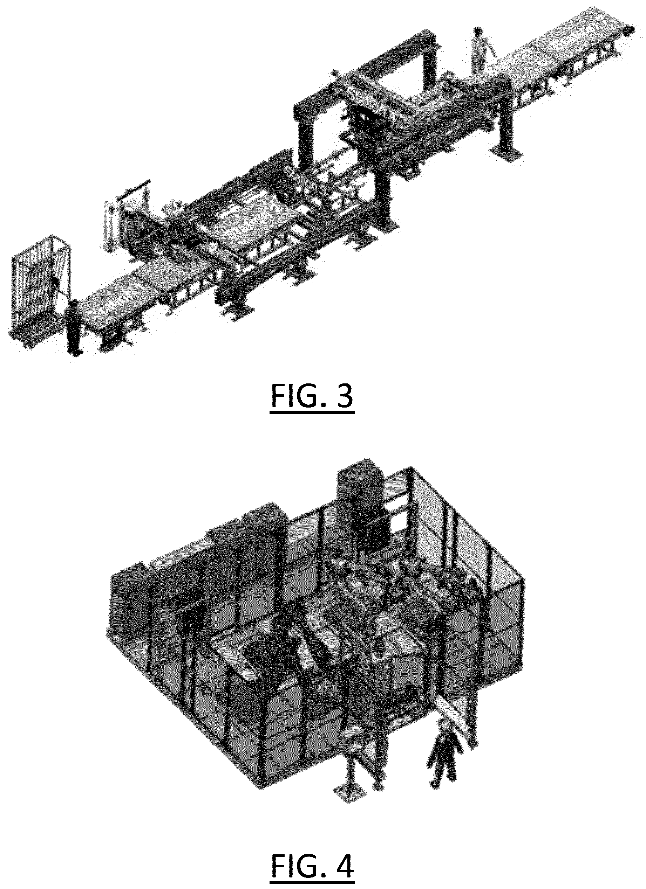

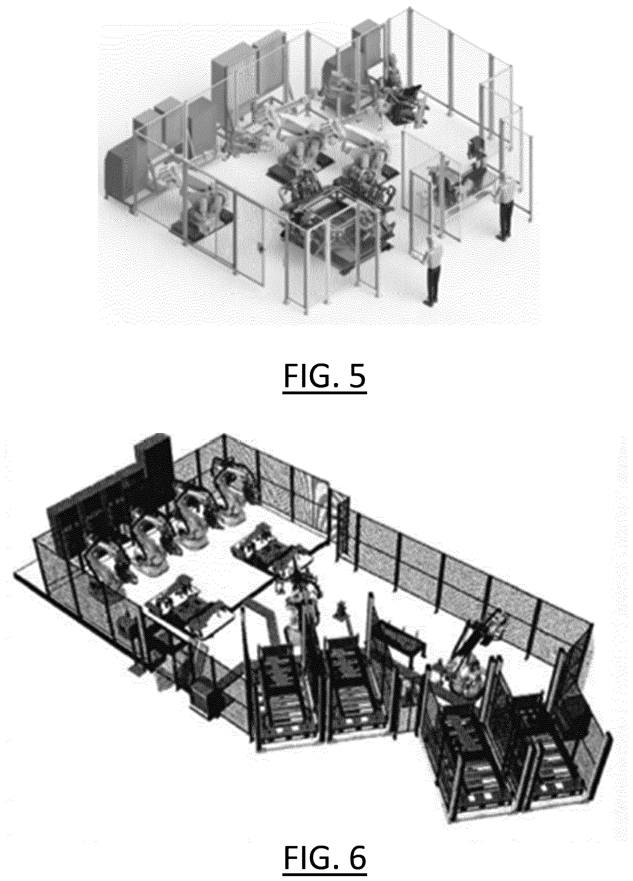

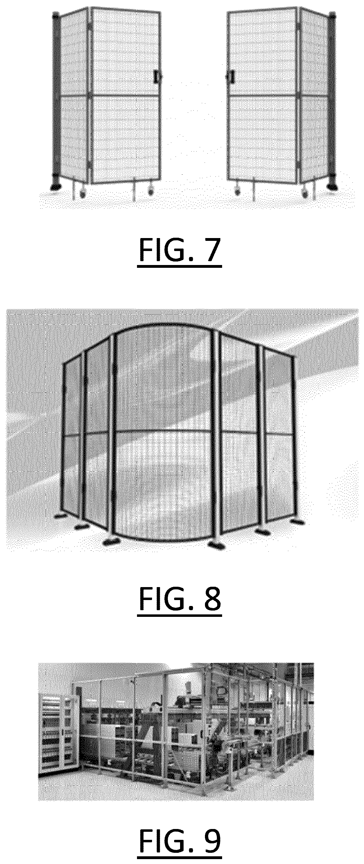

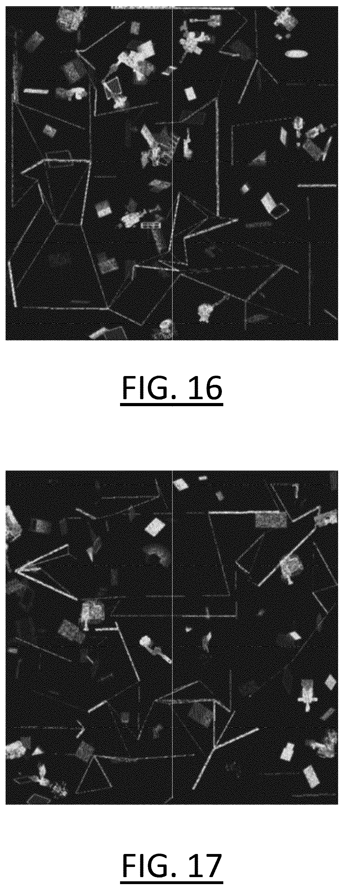

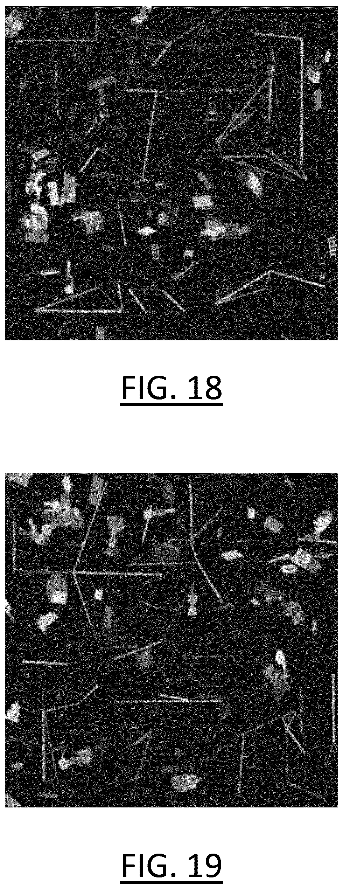

- FIG. 1 to 27 illustrate the methods;

- FIG. 28 shows an example of the system;

## DETAILED DESCRIPTION

It is therefore provided a computer-implemented method for segmenting a building scene. The method comprises providing a training dataset of top-down depth maps. Each depth map comprises labeled line segments and junctions between line segments. The method further comprises learning, based on the training dataset, a neural network. The neural network is configured to take as input a top-down depth map of a building scene comprising building partitions and to output a scene wireframe including the partitions and junctions between the partitions. The method if a method of machine-learning for segmentation of a building scene, and may be referred to as "the learning method".

The learning method forms an improved solution for scene segmentation.

Notably, the learning method yields and provides a neural network that is configured and trained for segmenting a building scene. The neural network is indeed trained to take as input a top-down depth map of a building scene that comprises building partitions (e.g. fences, walls) and to output a wireframe of the building scene formed by the partitions and the junctions between them. The neural network thereby outputs a segmentation of the scene into space units (e.g. rooms, working areas), delimited by partitions and junctions thereof. The method thereby forms a solution for segmentation of a building scene.

The method may notably be used for segmentation of factory scenes comprises work cells (e.g. robotic work cells) delimited by partitions (e.g. fences, such as security fences, for example for robotic cells) and junctions between the partitions. The learnt neural network may indeed take as input a depth map of such a scene and, thanks to its training, the neural network detects the partitions and the junctions in the scene and outputs a wireframe formed by these partitions and junctions. Thereby, the neural network outputs a wireframe of work cells of the scene. The learnt neural network thereby allows for factory scene segmentation, which may be of use for applications such as (e.g. automatic) plant twin generation (e.g. given a 3D scene) or analytics and production KPIs (key performance indicators) monitoring.

Furthermore, the learnt neural network may be used for segmenting a building scene of an input top-down depth map that stems from physical measurements (e.g. a scan), such as a depth map obtained from a 3D point cloud of a building scene, the 3D point cloud being itself obtained by scanning the scene with one or more appropriate physical sensors (e.g. lidars). For example, the provided depth map in the method of use may stem from scan of a real-world building scene (e.g. factory scene), or from a 3D point cloud that itself stem from such a scan. The neural network may thus in other words be used for measured (e.g. scanned) building scene segmentation and for determining a wireframe of such a scene.

Moreover, the neural network allows for automatic building scene segmentation. Indeed, the neural network may be applied automatically to an input depth map which automatically outputs a wireframe of the scene, without a need for user interactions. For example, in the method of use, the applying of the neural network may be done automatically, and subsequent steps of the method of use (if any) may be as well.

It is also provided a method of use of a neural network learnable by the method (e.g. having been learnt by the method). The method of use comprises providing a top-down depth map of a building scene comprising building partitions. The method of use further comprises obtaining, by applying the neural network to the provided top-down depth map, a wireframe of the building scene. The wireframe includes the partitions and junctions between the partitions. The method of use may be referred to as "the segmentation method".

The learning method and the segmentation method may be integrated into a same computer-implemented process for building scene segmentation. This process comprises first, as an offline stage, performing the learning method, which results in the learnt/trained neural network. Then the process comprises, as an online stage, performing the segmentation method, including applying the neural network to an provided input top-down depth map of a building scene comprising partition, thereby resulting in a wireframe of the scene including the partitions and junctions between the partitions.

The learning method is now further discussed.

The learning method is a method of machine-learning for segmenting a building scene, as the method learns a neural network configured for such a segmentation. Segmentation is the task of identifying all the points or pixels belonging to a particular object or area in a 3D or 2D scene. In the case of the method, the segmentation performed by the neural network is the identification of the wireframe of a building scene (including the partitions of the scene and junctions between the partitions) represented by a top-down depth map comprising building partitions.

A building scene is a portion of a real-world building, such as a factory (e.g. comprising robotic cells). Such a scene comprises partitions that altogether partition/segment the scene into space areas (e.g. rooms, working cells, robotic cells). The neural network trained by the method is trained to detect such a segmentation (by the partitions and the junctions between them) of a building scene for which the segmentation is not known, such as a building scene represented by a point cloud or a depth map (e.g. stemming from physical measurements by sensors). The partitions, also referred to as fences, are vertical structures that enclose specific areas, such as safety barriers or walls (e.g. around a robotic cells as discussed hereinafter). A partition thus refers to a vertical wall-like structure of the scene, e.g. having a height larger than a predefined threshold (e.g. 1m) and/or having a width larger than a predefined threshold (e.g. 1m).

The building may be a factory including work cells each delimited by partitions, the partitions altogether segmenting the factory into work cells. The partitions may also be referred to as fences. The work cells may also be referred to as work stations. A work cell corresponds to a working area including a grouping of manufacturing equipment (e.g. robots or robotic arms of a same type and/or performing a similar or same task). A work cell may in general be delimited or not by fences/partitions, but the method (or, rather, the neural network trained by the method) detects the partitions and their junctions and thus detects the fences around work cells comprising fences (in the case of an input building scene that is a factory with work cells). A robotic work cell is a work cell that contains at least one robotic arm. Robotic work cells are usually delimited by fences for safety purposes.

FIG.s 1 to 6 show images of examples real and virtual factory scenes with assembly lines and robotic cells. FIG.s 7 to 9 show examples of images of fences.

The learning method is a method of machine learning.

As known per se from the field of machine-learning, the processing of an input by a neural network includes applying operations to the input, the operations being defined by data including weight values. Learning a neural network thus includes determining values of the weights based on a dataset configured for such learning, such a dataset being possibly referred to as a learning dataset or a training dataset. For that, the dataset includes data pieces each forming a respective training sample. The training samples represent the diversity of the situations where the neural network is to be used after being learnt. Any training dataset herein may comprise a number of training samples higher than 1000, 10000, 100000, or 1000000, for example equal to 5000. In the context of the present disclosure, by "learning a neural network based on a dataset", it is meant that the dataset is a learning/training dataset of the neural network, based on which the values of the weights (also referred to as "parameters") are set.

In the context of the learning method, the training dataset is the provided dataset of top-down depth maps, which is now discussed. The providing of the dataset, and data structures involved therein, are now discussed.

The training dataset consists in top-down depth maps. A depth map is an image or an image channel that contains information relating to the distance of the surfaces of the objects of the scene (i.e. represented by the depth map) from a given viewpoint. The depth map consists in positions or pixels each representing a real-world space position and each associated with a depth value (i.e. the distance to a given viewpoint) representing the depth of the real-world position. It is to be noted that no further data on the depth map is required by the learning method (e.g. no color or intensity channel), which makes the learning method generic in terms of the input data that the trained neural network may handle.. Each depth map herein is a top-down depth map, which means that the view point is the above (e.g. ceiling) viewpoint of the scene, the distance being in this case a height. The depth maps of the training dataset are not, or at least not all, necessarily depth maps representing building scenes. The only requirement for these depth maps is that each one of them comprises line segments and junctions between the line segments, to mimic building scene depth maps. This does not exclude that at least some of the depth maps of the training dataset may be building scene depth maps. The line segments and the junctions (*i.e.* of each depth map of the training dataset) are labeled (*i.e.* as being line segments and junctions, respectively).

Providing the training dataset may comprise retrieving (e.g. downloading) existing top-down depth maps from a (e.g. distant) memory or server or database, the retrieved top-down depth maps forming the training dataset or at least a part thereof. Providing the training dataset may alternatively comprise creating (i.e. synthesizing) at least some or all of the top-down depth maps, by any suitable method, and labelling the segments and junctions therein.

Further to the providing of the training dataset, the method then comprises learning a neural network based on the training dataset.

The neural network is herein a data structure consisting of layers of neurons with weights, as known *per se* from machine-learning and as discussed previously. Learning the neural network comprises iteratively modifying the weights of the neural network as long as the neural network does not produce satisfactory outputs with respect to the top-down depth maps of the training dataset, which are fed as input to the neural network during the training. Specifically, the neural network is trained to output, for a given input top-down depth map of a building scene comprising building partitions, a scene wireframe including the partitions and junctions between the partitions. During training, the neural network is iteratively, successively, fed with the labeled maps of the training dataset, and for each input map, the neural network outputs a wireframe corresponding to the map, *i.e.* the neural network identifies the segments and their junctions so as to form a wireframe. The learning is based on the labels, i.e. the output wireframe must be consistent with the labeling of the segments and their junctions, and the weight of the network are modified until the network outputs wireframes consistent with the labeling of the input maps of the training dataset. The learning may be supervised: it uses the labels to verify the consistency or the discrepancy between the labels of the inputs of the network and the outputs of the neural network, to modify the weights as long as there is no consistency, or not enough consistency (e.g. with respect to a convergence criterion, such as a sufficient smallness of a loss).

The neural network learnt by the method may be a Deep Neural Network (DNN). DNNs are a powerful set of techniques for learning in Neural Networks (as discussed in reference Rumelhart et al. Learning internal representations by error backpropagation, 1986, which is incorporated herein by reference) which is a biologically-inspired programming paradigm enabling a computer to learn from observational data. In object recognition, the success of DNNs is attributed to their ability to learn rich midlevel media representations as opposed to hand-designed low-level features (Zernike moments, HOG, Bag-of-Words, SIFT, etc.) used in other methods (mincut, SVM, Boosting, Random Forest, etc.). More specifically, DNNs are focused on end-to-end learning based on raw data. In other words, they move away from feature engineering to a maximal extent possible, by accomplishing an end-to-end optimization starting with raw features and ending in labels.

The neural network may in example be the convolutional neural network called HAWP and discussed in reference Nan Xue, Tianfu Wu, Song Bai, Fudong Wang, Gui-Song Xia1, Liangpei Zhang, Philip H.S. Torr, Holistically-Attracted Wireframe Parsing, CVPR, 2020, which is incorporated herein by reference. This means that the neural network has the HAWP architecture, although the learning method performs a training of the weights of this architecture which is specific to the learning method. HAWP is an end-to-end trainable wireframe detector on images, published in 2020, and which, achieves state-of-the-art results in terms of accuracy and efficiency, compared to previous methods. Other neural network architectures may alternatively be used, for example the L-CNN discussed in reference Yichao Zhou, Haozhi Qi, Yi Ma, End-to-End Wireframe Parsing, ICCV, 2019, which is incorporated herein by reference.

It is to be noted that the training samples (i.e. the depth maps of the training dataset) are not necessarily depth maps representation of real building scenes. Yet, as they comprise segments and junctions between the segments, they form a suitable basis for training the neural network to extract wireframes from actual building scene depth maps, since the neural network is thereby trained to detect the line segments and junctions that form the wireframe of the building scene. Furthermore, using training depth maps which are not necessarily building scenes depth maps (or at least, not all of them), allows to simplify the creating of the training dataset. For example, the depth maps may be synthesized (i.e. virtually generated), which avoids using depth maps from real scenes, often complicated or even impossible to obtain (for example in the case of factory scenes, due to confidentiality matters).

A line segment of a depth map is herein a collection of points of the depth map that form a line segment in its geometrical/mathematical meaning (that is, a line having extremal ending points). The points or pixels forming the line segment in the depth map may all have the same height or substantially the same height (e.g. the same height up to a small threshold). A junction is herein an intersection between two line segments. A wireframe is herein a collection of line segments and junctions between them that form a representation of the partitions and junctions between the partitions of a building scene.

Each top-down depth map of the training dataset may comprise random points (i.e. points having random positions) and line segments each between a respective pair of points. The line segments have random heights. Whether the providing of the training dataset comprises the creation of the depth maps thereof or this creation is carried out beforehand (i.e. upstream to the learning method), the creation of the dataset of top-down depth maps may thus comprise, for each depth map, generating random points in an image space. The random generation may be uniformly random: points are generated one by one, with a probability p of being aligned along an axis X or Y with an existing (randomly chosen) point. p grows from 0 to 1 uniformly while generating points. Being aligned with another point along axis X or Y means that the coordinate is modified with a Gaussian noise, and that the other coordinate is random. The creation of the training dataset may then comprise creating the line segments between the points, i.e. selecting lines as pairs of points. For example, this may comprise adding in lines during two steps, one by one, while taking care not to override existing lines. One step consists in adding lines linking aligned points, and the other in adding any line. A line candidate is every pair of points, distant of less than a certain value. A generation probability may be associated with each possible line candidate, depending on the line lengths. Coordinates may be saved in order to be used during the training. Lines may be then drawn on the image. The creation may then comprise randomly associating a height and a width to each line. Considering the line widths and endpoints, this may include selecting the pixel inliers of each line, and assigning to each pixel the value of its line height, and to pixels with no line a 0 value. Using as training samples depth maps with random points and random heights for the line segments allows to have a training dataset with great variability, which imparts robustness to the neural network. Indeed, the later, during training, is confronted with a great variability of line segments configurations (representing various heights of the real-world partitions) in depth maps and thus learns in a robust manner to correctly detect these segments and their junctions.

Each top-down depth map of one or more top-down depth maps of the training dataset (for example, each depth map of the training dataset) may comprise one or more distractors. A distractor is any other object than a line segment, i.e. any geometric object on the depth map image that is not a line segment. Adding distractor to the depth maps improve robustness of the training and of the neural network. Indeed, real building scenes (i.e. those which are fed as input to the neural network during use), may comprise in general objects which are not partitions. For example, a factory scene with working (e.g. robotic) cells comprise manufacturing equipment such as robotic arms, conveyors, forklift, containers, boxes and/or pallets. The distractors in the training dataset play the role of these objects during training, which trains the neural network in recognizing them and not mistaking them for partition when actually encountering them during use. Whether the providing of the training dataset comprises the creation of the depth maps thereof or this creation is carried out beforehand (i.e. upstream to the learning method), the creation of the dataset of top-down depth maps may comprise adding distractors to at least a part (e.g. all) of the depth maps. This may comprise pre-generating a dataset of depth maps of objects from 3D models of these objects, and adding them in the depth maps of the training dataset. The objects considered and used may be manufacturing equipment such as robotic arms, conveyors, forklift, containers, boxes and pallets. From such a dataset, the addition of a distractor to a given depth map image may comprise: selecting a random object image, a random length and width and a random height; re-scaling the image according to its length and width; multiplying its individual pixel values by its height; adding the object image at a random position on the base depth map image (each pixel takes the maximum value between the old and new value). This may include ensuring that robots and other high objects do not override lines.

Each top-down depth map of one or more top-down depth maps of the training dataset (for example, each depth map of the training dataset) may comprise noise. This allows to train the training dataset on depth maps with noise and thereby to improve robustness of the training and of the neural network. Indeed, the depth maps that the neural network is used on during use may comprise noise, for example if they stem from physical measurements with sensors (e.g. if they stem from a scan). The noise in the depth maps of the training dataset allows to mimic such real-world noise and to thereby improve robustness of the neural network when encountering noise. Whether the providing of the training dataset comprises the creation of the depth maps thereof or this creation is carried out beforehand (i.e. upstream to the learning method), the creation of the dataset of top-down depth maps may comprise adding noise to at least a part (e.g. all) of the depth maps. This may comprise, randomly selecting pixels of one or more depth maps from those that have non-zero values (by being an inlier or on an object), and for each selected pixel introducing a dropout probability. This means that the pixel has a certain probability of being kept at a zero value. Adding noise may also comprise inserting holes by producing circles with a random center and radius and assigning pixels within this circle with a probability of being zero.

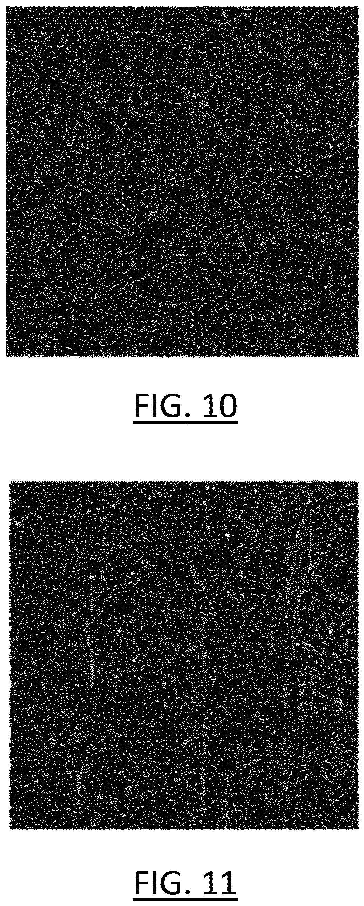

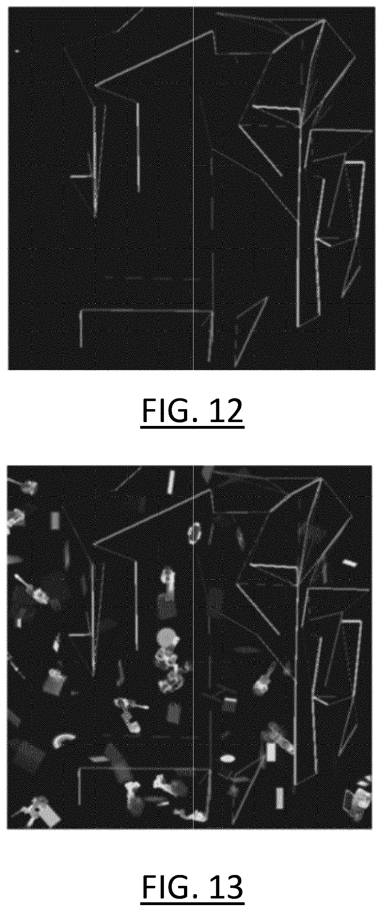

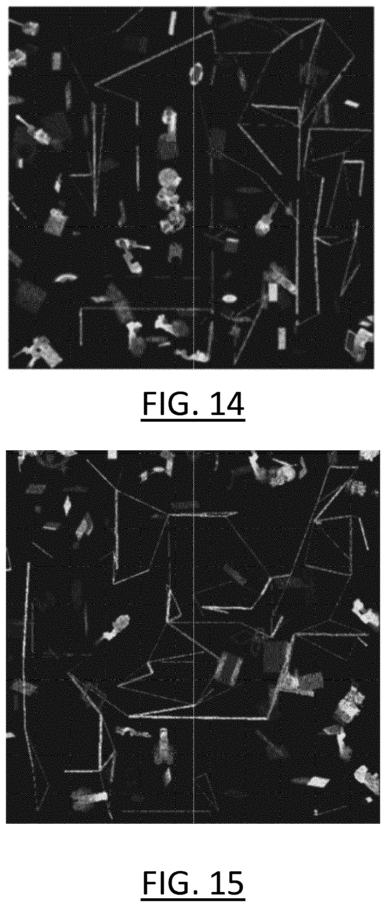

FIG.s 10 to 14 illustrate an example of the creation of a depth map of the training dataset. FIG 10 illustrates the generation of random points on an image. FIG. 11 illustrates the subsequent generation of line segments between the points. FIG. 12 illustrates the association of random heights to the line segments. FIG. 13 shows the addition of distractors to the image. FIG. 14 illustrates the addition of noise to the image, and thereby FIG. 14 shows an example of a depth map image which forms a part of the training dataset. FIG.s 15 to 20 show other examples of depth maps image which may be training samples of the training dataset.

The above-discussed process for generating the learning dataset allows to generate synthetic depth maps that mimics top-down depth maps generated from real scans, for example factory scans.

The segmentation method is now further discussed.

The segmentation method comprises providing a top-down depth map of a building scene comprising building partitions. Providing the top-down depth map may comprise retrieving (e.g. downloading) an existing depth map from a *(e.g. distant)* memory or server or database. Providing the top-down depth map may alternatively comprise obtaining the top-down depth map, for example by obtaining the top-down depth map from a 3D point cloud. In other words, the provided top-down depth map may stem from a 3D point cloud representing a building scene.

A point cloud is an unordered set of points with coordinates (in 3D if the point cloud is a 3D point cloud) that may be accompanied with additional characteristics such as intensity or color. The unordered aspect of this data makes it really hard to analyze, especially compared to structured grid such as images. Different formats of point clouds exist and they may heavily depend on the sensor used to capture the 3D scan from which the point cloud may stem. Note that, nowadays, state-of-the art sensors are able to provide clouds of millions of point giving very dense 3D scans of very high quality. Point clouds can be also generated from other 3D representation such as CAD or meshes.

Obtaining the top-down depth map from the 3D point cloud may be carried out as follows. Given the point cloud, obtaining the depth map may comprise computing first the floor height using RANSAC algorithm (discussed in reference Martin A. Fischler and Robert C. Bolles, SRI International, "Random Sample Consensus: A Paradigm for Model Fitting with Applications to Image Analysis and Automated Cartography", 1981, which is incorporated herein by reference). This algorithm returns, after a few iterations, a plane that fits a high number of points. The obtaining of the depth map may then comprise checking that the plane is eligible as the floor: it should be horizontal and relatively low compared to the point cloud. While such a plane is not found, the obtaining may repeat the RANSAC procedure. Once a satisfactory plane is found, the obtaining sets the floor height to be the mean height (Z value) of the plane inliers. Obtaining the depth map from the 3D point cloud may then further comprise choosing the height range, for example 0.5-2m, relatively to the floor height. It corresponds to a range that would cover part of any fence, on the other hand it should discard most other useless objects or artefacts. Only points within this range are considered to compute the depth map. Any alternative to the RANSAC algorithm (as discussed for example in Rahul Raguram, Jan-Michael Frahm, and Marc Pollefeys: "A Comparative Analysis of RANS-AC Techniques Leading to Adaptive Real-Time Random Sample Consensus", ECCV 2008, which is incorporated herein by reference), or any other method to compute a top-down depth map from a point cloud may alternatively be used instead of the RANSAC method.

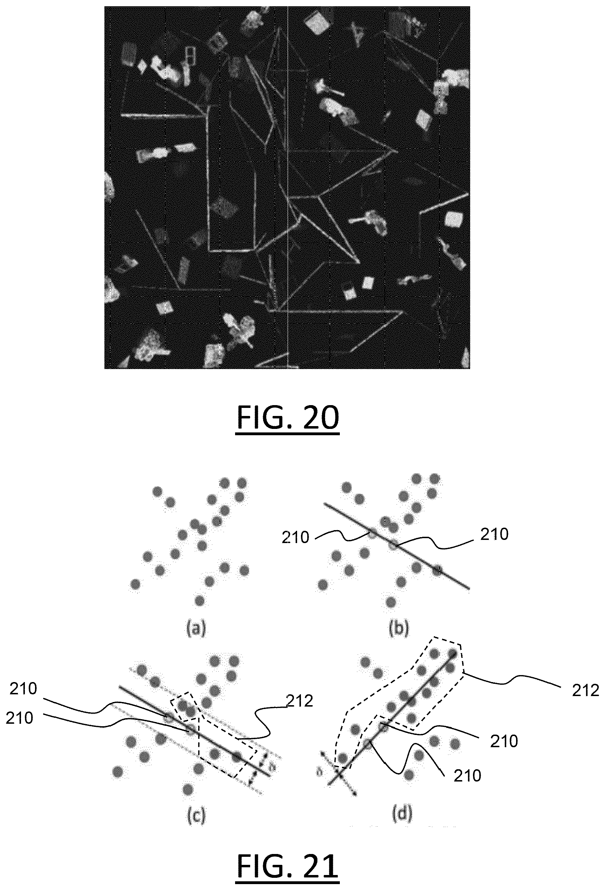

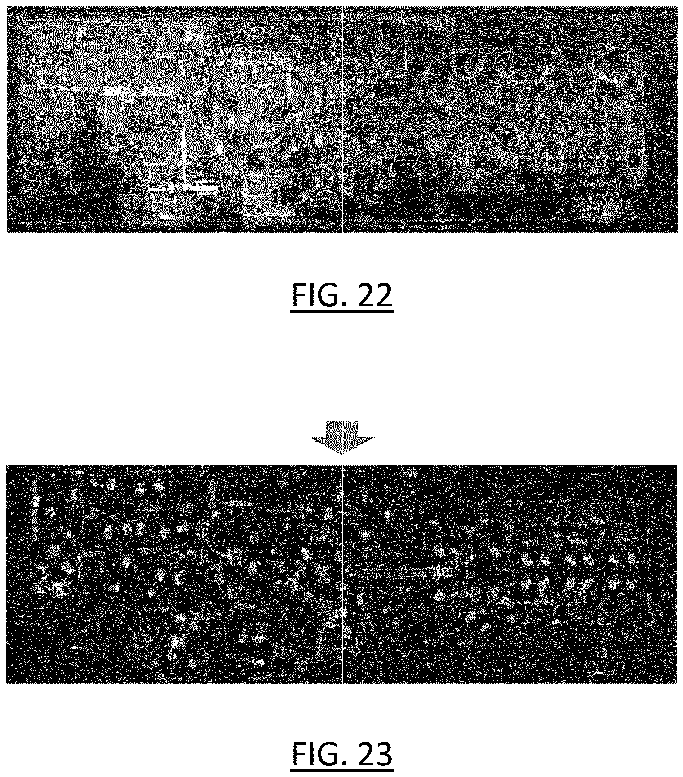

RANSAC (Random Sample Consensus) is a simple, generic and nondeterministic algorithm that aims at estimating the parameters of some mathematical models. The method is based on the assumption that the data is composed of inliers (data points which distribution can be explained by the parameters of a mathematical model) and outliers. It also assumes that given a small subset of data points, one can estimate the parameters of the optimal model that explains these points. The algorithm works iteratively the following way. A small data sample is chosen among the data. The parameters of the optimal model fitting this sample are computed. Then, the algorithm looks at the proportion of data points in the whole dataset that is considered as inliers using these parameters. The algorithm keeps the parameters for which the highest data proportion is considered as inliers. To illustrate this, one may take the example of 3D planes as a mathematical model that has to fit the most points in a 3D point cloud. Planes can be described using 4 real valued parameters corresponding to the Cartesian equation. At each iteration of RANSAC, the sample is a set of three non-collinear random points. The plane fitting the best is the only plane that passes through all three points. For 2D lines, it is exactly the same approach as shown on the figure below. FIG. 21 illustrates the RANSAC algorithm, with the sampled points 210, the inliers (the points comprised within the dotted lines 212) and the outliers (the remaining points). FIG. 22 shows a top view point cloud of a factory scene, and FIG. 23 shows a depth maps generated thereof using the RANSAC method.

Further to the providing of the top-down depth map of a building scene, the segmentation method then comprises obtaining, by applying the neural network to the provided top-down depth map, a wireframe of the building scene. The wireframe includes the partitions of the scene and junctions between the partitions, because the neural network has been trained to detect them.

The segmentation method may further comprise computing 2D regions of the provided depth map by extracting, from the obtained wireframe, 2D regions of which contours are formed by line segments of the obtained wireframe. Computing the 2D regions may comprise providing (e.g. creating/generating) a graph. The graph comprises graph nodes each representing a junction and graph edges each representing a line segment between two junctions represented two graph nodes. Each graph edge comprises two half-edges having opposite orientations. In other words, there are two possible edge orientations in the graph and each one of the two half-edges correspond to the graph edge with one of the orientations. Computing the 2D regions then comprises determining, using the half-edges (i.e. to traverse the graph): regions of the graph delimited by graph edges and not crossed by any graph edge (i.e. regions of the graph each formed by a cycle of half-edges and crossed by no other graph edge), and overall edge contours of the graph (i.e. contours formed by edges cycles). This determination correspond to the identifications of 2D regions of the depth maps delimited by line segments and not crossed by any line segments, as well as overall contours of the depth maps delimited by line segments.

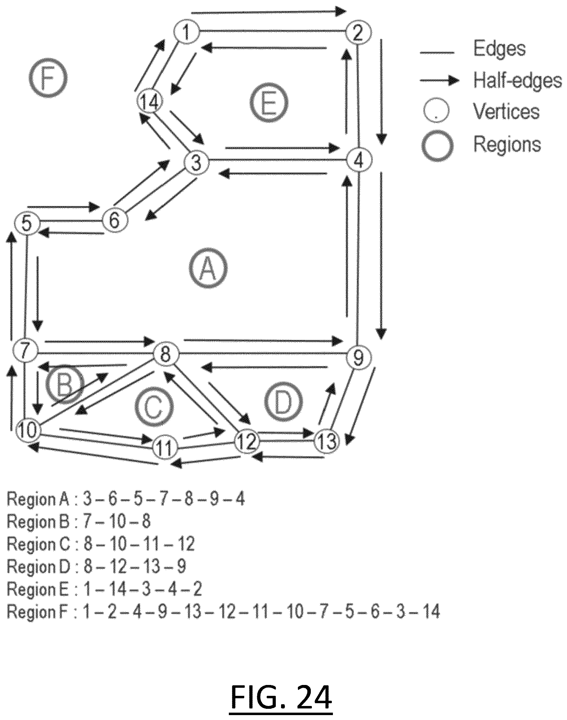

Computing the regions using the graph may be carried out as follows, to extract regions which contours are the previously proposed lines. First, a graph is built using junctions as vertices and lines as edges. This may comprise discarding leaves, so that each edge belong to at least one cycle, using queues: removing a leaf can make another leaf. The procedure for extracting the 2D regions may be as follows the following (as illustrated on FIG. 24):

- choose an unvisited half-edge (i.e. edge with an orientation, having a starting and an ending vertex), mark it as visited and compute the region to which this half-edge belongs. For this, first find the edge's successor: a half-edge that starts with the ending vertex v of the current half-edge, it is the leftmost half-edge arriving from the current half-edge to v.
- The successor becomes then the current half-edge and the current half-edge is marked as visited.
- Repeat this procedure until arriving back to the initial half-edge of the region. This list of half-edges describes the region found.
- Then, start again with a new region using as starting point a new half-edge;

Thanks to this procedure described above, the method gets the regions delimited by edges without any edge crossing it, and overall contours (exterior regions as region F on the figure). FIG. 24 illustrates an example of the regions computation on the graph, where regions A, B, C, D, and E have been identified as closed loops of half edges and not being crossed by edges, and F has been identified has an overall contour.

Computing the 2D regions may further comprise computing, using the Shoelace formula (i.e. by computing the areas of the determined regions and contours according to the Shoelace formula), the areas of each determined region of the graph and overall edge contour of the graph. Computing the 2D regions may then further comprise discarding (i.e. excluding as 2D regions), using the computed areas: regions having a negative area (i.e. contours, for which the Shoelace formula provides a negative area), regions having an area lower than a predefined threshold, and regions having a width lower than a predefined threshold.

The Shoelace formula is discussed in reference James Tanton, Mathematical Association for America, Computing Areas, 2014, which is incorporated herein by reference. The Shoelace formula allows to compute the area of each extracted region and contours. If it is an overall contour, the formula gives a negative result. Using this formula, the method filters out regions based on two relevant criteria: minimal area, i.e. too small regions are discarded as they cannot be assimilated to spaces delimited by partitions and junctions (e.g. work cells), and minimal width, i.e. too thin regions also discarded. In order to define the width of a region, the method may compare the area of each region with the maximal squared distances between junctions delimiting the region.

The shoelace formula is used to compute the area of a 2D general polygon (general in the sense that it is not necessarily regular nor convex). From the Shoelace formula, the method uses a methodology for determining if 2D points are contained in those general polygons, which is the following. Let the polygon be represented by an ordered set of points $\{p_1 .., p_n\}$. Choose a reference point p in the space (any point) and compute the vectors $\{v_1, .., v_n\}$ corresponding to $\{p_1 .., p_n\}$ with p as an origin. The area of the polygon is the weighted sum of the areas of the triangles $(pp_ip_{i+1})$, with weights equal to 1 or -1. The shoelace formula gives the area of the polygon A with respect to $\{v_1, .., v_n\}$:

$$A = \sum_{i=1}^{n-1} \frac{v_i \times v_{i+1}}{2} + \frac{v_n \times v_1}{2},$$

$\frac{v_i \times v_{i+1}}{2}$ being the weighted area of the $(pp_ip_{i+1})$ triangle, with x the cross product.

Now let be $\{x_1, .., x_m\}$ be a set of points in the plane. It is to be determined which of these points belongs to the polygon parameterized by $\{p_1 .., p_n\}$. Let assign to each point $x_i$ a counter $c_i$ initialized at zero. Consider the triangles $(pp_1p_2)$, $(pp_2p_3)$,... $(pp_{n-1}p_n)$, $(pp_np_1)$ are considered. For each of these triangles, the method checks which of the points in $\{x_1,..,x_m\}$ belongs to the interior of the triangle. This is easily done for example using dot products on the normal vector of each three segment of the triangle and the relative coordinates of points. Each point $x_i$ that is inside the triangle should have its counter $c_i$ incremented by one. After this has been done for each of the triangle, the method looks at whether $c_i$ is odd or even to determine if $x_i$ is inside the polygon: if p is outside the polygon, then the counters is odd, and if p is outside, then it is even. In practice, the method may choose p outside the polygon by taking its coordinates lower than the minimum of those of $\{p_1 .., p_n\}$.

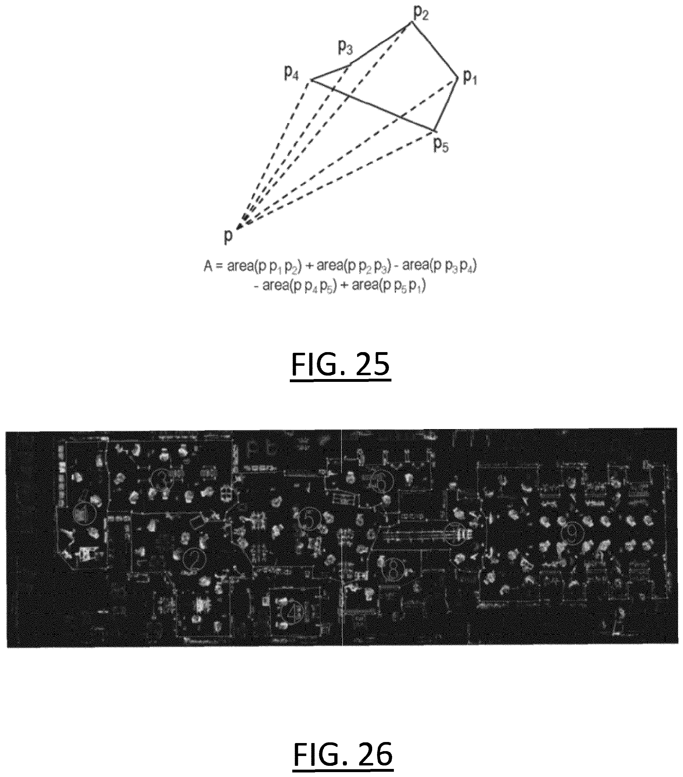

FIG. 25 illustrates the shoelace formula.

As previously said, the provided depth map may stem from a 3D point cloud. In this case, the method may further comprise projecting the computed 2D regions on the 3D point cloud, thereby obtaining a 3D segmentation of the building scene. Projecting the 2D regions identified on the provided depth map on the 3D point cloud from which the depth map stems may be carried out by any suitable method known for this purpose. For example, this may comprise projecting each point of the 3D point cloud onto the segmented 2D depth maps (i.e. with the identified regions that result from the discarding step) and associating each point with the 2D region on which it is projected, thereby effectively segmenting the 3D point cloud in accordance with the identified 2D regions.

The provided depth map and/or the 3D point cloud may stem from physical measurements, i.e. the provided depth map and/or the 3D point cloud may have been acquired by one or more physical sensors (e.g. lidars) positioned on the corresponding building scene during a scanning process of the scene. The segmentation method may comprise such a scanning process as an initial step, or may alternatively simply comprise retrieving the result of such a scanning process when providing the depth map and/or the point cloud.

The method may further comprise filtering the obtained wireframe by discarding partitions and/or junctions not satisfying a neural network prediction confidence score criterion (e.g. for which the neural network has a too small prediction confidence score) and/or satisfying a smallness criterion (e.g. partitions which are too small disconnected lines). In other words, the filtering is an optional post-processing that the method may comprise and apply to the output wireframe detected by the neural network. This filtering allows to simplify the predicted wireframe and discard unwanted partitions and/or junctions by using the above mentioned criterion/criteria. For example, the neural network (e.g. the HAWP neural network, as previously discussed) may output, besides junctions and partitions, a respective confidence score for each outputted/detected junction or partition. The score criterion may in this case be that the confidence score must be larger than or equal to a threshold, for example 0.2 (i.e. all junctions and partitions for which the confidence score is lower than the threshold (e.g. 0.2) are discarded). The smallness criterion may be to discard small unconnected lines (i.e. unlikely to belong to a building partition), for example by discarding those having a length lower than a threshold of 10% of min(w,h) where w is the width of the depth map image and h is its height.

FIG. 26 illustrates the 2D regions 1 to 9 detected on the depth map of FIG. 23, and which represent work cells (delimited by lines representing their fences).

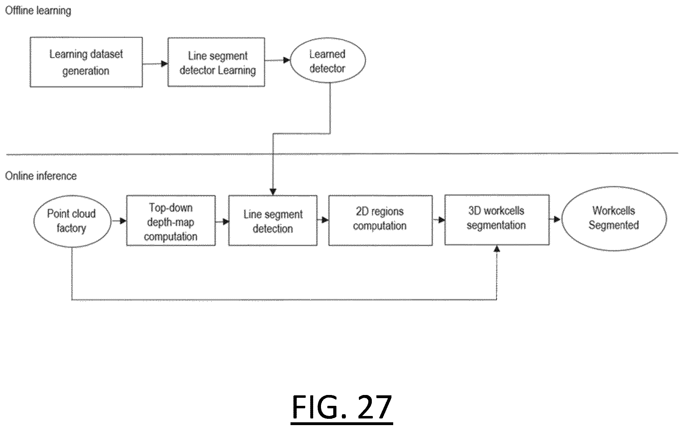

As previously discussed, the learning method and the segmentation method may be integrated into a same process. FIG. 27 shows a flowchart of an example of such process. As it can be seen on FIG. 27, the learning method forms the offline stage of the process and the segmentation method forms the online stage. This is a pattern typical of learning-based methods which typically follow the same kind of pattern; they have an offline stage, in which intensive computations may be performed, and on online stage in which performance is the key as to achieve the targeted task given the input data. The offline stage in FIG. 27 stage aims at training a detector of line segments and junctions from depth maps. It contains two main steps and is transparent from the end user. The main steps are: 1) A depth map dataset generation (or collection) step, and 2) A detector learning based on the generated (or collected) dataset. The online stage proceeds then as follows: given a point cloud factory, first a 2D top-down depth map is computed. Second, line segments and junctions are detected using the learned detector. Then, 2D regions are computed based on the detected line segments. Finally, the 3D segments (e.g. work cells) are identified given those regions as well as the projection of the point cloud into the image space.

The methods are computer-implemented. This means that steps (or substantially all the steps) of the methods are executed by at least one computer, or any system alike. Thus, steps of the methods are performed by the computer, possibly fully automatically, or, semi-automatically. In examples, the triggering of at least some of the steps of the methods may be performed through user-computer interaction. The level of user-computer interaction required may depend on the level of automatism foreseen and put in balance with the need to implement user's wishes. In examples, this level may be user-defined and/or pre-defined.

A typical example of computer-implementation of a method is to perform the method with a system adapted for this purpose. The system may comprise a processor coupled to a memory and a graphical user interface (GUI), the memory having recorded thereon a computer program comprising instructions for performing the method. The memory may also store a database. The memory is any hardware adapted for such storage, possibly comprising several physical distinct parts (e.g. one for the program, and possibly one for the database).

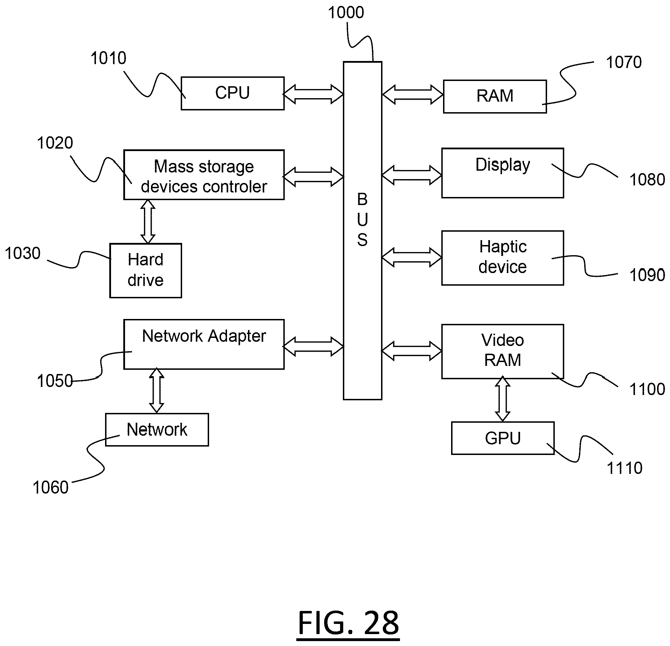

FIG. 28 shows an example of the system, wherein the system is a client computer system, e.g. a workstation of a user.

The client computer of the example comprises a central processing unit (CPU) 1010 connected to an internal communication BUS 1000, a random access memory (RAM) 1070 also connected to the BUS. The client computer is further provided with a graphical processing unit (GPU) 1110 which is associated with a video random access memory 1100 connected to the BUS. Video RAM 1100 is also known in the art as frame buffer. A mass storage device controller 1020 manages accesses to a mass memory device, such as hard drive 1030. Mass memory devices suitable for tangibly embodying computer program instructions and data include all forms of nonvolatile memory, including by way of example semiconductor memory devices, such as EPROM, EEPROM, and flash memory devices; magnetic disks such as internal hard disks and removable disks; magneto-optical disks. Any of the foregoing may be supplemented by, or incorporated in, specially designed ASICs (application-specific integrated circuits). A network adapter 1050 manages accesses to a network 1060. The client computer may also include a haptic device 1090 such as cursor control device, a keyboard or the like. A cursor control device is used in the client computer to permit the user to selectively position a cursor at any desired location on display 1080. In addition, the cursor control device allows the user to select various commands, and input control signals. The cursor control device includes a number of signal generation devices for input control signals to system. Typically, a cursor control device may be a mouse, the button of the mouse being used to generate the signals. Alternatively or additionally, the client computer system may comprise a sensitive pad, and/or a sensitive screen.

The computer program may comprise instructions executable by a computer, the instructions comprising means for causing the above system to perform the method. The program may be recordable on any data storage medium, including the memory of the system. The program may for example be implemented in digital electronic circuitry, or in computer hardware, firmware, software, or in combinations of them. The program may be implemented as an apparatus, for example a product tangibly embodied in a machine-readable storage device for execution by a programmable processor. Method steps may be performed by a programmable processor executing a program of instructions to perform functions of the method by operating on input data and generating output. The processor may thus be programmable and coupled to receive data and instructions from, and to transmit data and instructions to, a data storage system, at least one input device, and at least one output device. The application program may be implemented in a high-level procedural or object-oriented programming language, or in assembly or machine language if desired. In any case, the language may be a compiled or interpreted language. The program may be a full installation program or an update program. Application of the program on the system results in any case in instructions for performing the method. The computer program may alternatively be stored and executed on a server of a cloud computing environment, the server being in communication across a network with one or more clients. In such a case a processing unit executes the instructions comprised by the program, thereby causing the method to be performed on the cloud computing environment.

**Claims**

1. A computer-implemented method for segmenting a building scene, the method comprising:

   - providing a training dataset of top-down depth maps, each depth map comprising labeled line segments and junctions between line segments;

   and
   - learning, based on the training dataset, a neural network, the neural network being configured to take as input a top-down depth map of a building scene comprising building partitions and to output a scene wireframe including the partitions and junctions between the partitions.

2. The method of claim 1, wherein each top-down depth map of the training dataset comprises:

   - random points, and
   - line segments each between a respective pair of points, the line segments having random heights.

3. The method of claim 1 or 2, wherein one or more top-down depth maps of the training dataset comprise one or more distractors, a distractor being any other object than a line segment.

4. The method of claim 2 or 3, wherein one or more of the top-down depth maps comprise noise.

5. A neural network learnable according to the method of any one of claims 1 to 4.

6. A method of use of a neural network according to claim 5, the method of use comprising:

   - providing a top-down depth map of a building scene comprising building partitions; and
   - obtaining, by applying the neural network to the provided top-down depth map, a wireframe of the building scene, the wireframe including the partitions and junctions between the partitions.

7. The method of claim 6, wherein the method further comprises computing 2D regions of the provided depth map by extracting, from the obtained wireframe, 2D regions of which contours are formed by line segments of the obtained wireframe.

8. The method of claim 7, wherein computing the 2D regions comprises

   - providing a graph comprising:

     ◦ graph nodes each representing a junction, and
     ◦ graph edges each representing a line segment between two junctions represented two graph nodes, each graph edge comprising two half-edges having opposite orientations; and

   - determining, using the half-edges:

◦ regions of the graph delimited by graph edges and not crossed by any graph edge, and

◦ overall edge contours of the graph.

9. The method of claim 8, wherein computing the 2D regions further comprises:

- computing, using the Shoelace formula, the areas of each determined region of the graph and overall edge contour of the graph; and
- discarding, using the computed areas:

◦ regions having a negative area,
◦ regions having an area lower than a predefined threshold, and
◦ regions having a width lower than a predefined threshold.

10. The method of any one of claims 7 to 9, wherein the provided depth map stems from a 3D point cloud, and the method further comprises:

- projecting the computed 2D regions on the 3D point cloud, thereby obtaining a 3D segmentation of the building scene.

11. The method of any one of claims 6 to 10, wherein the provided depth map and/or the 3D point cloud stems from physical measurements.

12. The method of any one of claims 6 to 11, wherein the method further comprises filtering the obtained wireframe by discarding partitions and/or junctions not satisfying a neural network prediction confidence score criterion and/or satisfying a smallness criterion.

13. A computer program comprising instructions for performing the method of any one of claims 1 to 4 and/or the method of any one of claims 6 to 12.

14. A device comprising a computer-readable data storage medium having recorded thereon the computer program of claim 13 and/or the neural network of claim 5.

15. The device of claim 14, further comprising a processor coupled to the data storage medium.

## FIG. 1

## FIG. 2

FIG. 3

FIG. 4

## FIG. 5

## FIG. 6

FIG. 7

FIG. 8

FIG. 9

FIG. 10

FIG. 11

FIG. 12

FIG. 13

FIG. 14

FIG. 15

FIG. 16

FIG. 17

FIG. 18

FIG. 19

FIG. 20

FIG. 21

FIG. 22

FIG. 23

Region A : 3 – 6 – 5 – 7 – 8 – 9 – 4
Region B : 7 – 10 – 8
Region C : 8 – 10 – 11 – 12
Region D : 8 – 12 – 13 – 9
Region E : 1 – 14 – 3 – 4 – 2
Region F : 1 – 2 – 4 – 9 – 13 – 12 – 11 – 10 – 7 – 5 – 6 – 3 – 14

FIG. 24

$$A = area(p\,p_1\,p_2) + area(p\,p_2\,p_3) - area(p\,p_3\,p_4)$$
$$- area(p\,p_4\,p_5) + area(p\,p_5\,p_1)$$

FIG. 25

FIG. 26

Offline learning

```
┌─────────────────┐      ┌─────────────────┐      ╭───────────╮
│ Learning dataset│─────▶│  Line segment   │─────▶│  Learned  │
│   generation    │      │ detector Learning│     │  detector │
└─────────────────┘      └─────────────────┘      ╰───────────╯
```

Online inference

```
╭──────────╮   ┌──────────┐   ┌──────────┐   ┌──────────┐   ┌──────────┐   ╭──────────╮
│Point cloud│─▶│ Top-down │─▶│Line segment│─▶│2D regions│─▶│3D workcells│─▶│ Workcells │
│ factory   │  │depth-map │  │ detection  │  │computation│ │segmentation│  │ Segmented │
╰──────────╯   │computation│ └──────────┘   └──────────┘   └──────────┘   ╰──────────╯
```

# FIG. 27

FIG. 28

Europäisches
Patentamt

European
Patent Office

Office européen
des brevets

# EUROPEAN SEARCH REPORT

Application Number

EP 22 30 6072

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | YU LEQUAN ET AL: "EC-Net: An Edge-Aware Point Set Consolidation Network", 6 October 2018 (2018-10-06), SAT 2015 18TH INTERNATIONAL CONFERENCE, AUSTIN, TX, USA, SEPTEMBER 24-27, 2015; [LECTURE NOTES IN COMPUTER SCIENCE; LECT.NOTES COMPUTER], SPRINGER, BERLIN, HEIDELBERG, PAGE(S) 398 - 414, XP047488245, ISBN: 978-3-540-74549-5 [retrieved on 2018-10-06] | 1-6, 11-15 | INV. G06T7/11 G06T7/162 G06T17/20 |
| Y | * figures 2,4 * | 2 | |
| A | | 7-10 | |
| | ----- | | |
| Y | ZHOU KAIYUE ET AL: ""Zero-Shot" Point Cloud Upsampling", 2022 IEEE INTERNATIONAL CONFERENCE ON MULTIMEDIA AND EXPO (ICME), IEEE, 18 July 2022 (2022-07-18), pages 1-6, XP034175710, DOI: 10.1109/ICME52920.2022.9859662 [retrieved on 2022-08-26] * Section 4.1 * | 2 | |
| | | | TECHNICAL FIELDS SEARCHED (IPC) |
| | ----- | | G06T |
| A | HUANG KUN ET AL: "Learning to Parse Wireframes in Images of Man-Made Environments", 2018 IEEE/CVF CONFERENCE ON COMPUTER VISION AND PATTERN RECOGNITION, IEEE, 18 June 2018 (2018-06-18), pages 626-635, XP033476023, DOI: 10.1109/CVPR.2018.00072 [retrieved on 2018-12-14] * page 630 * | 3,4 | |
| | ----- | | |
| | -/-- | | |

The present search report has been drawn up for all claims

| Place of search | Date of completion of the search | Examiner |
|---|---|---|
| Munich | 8 February 2023 | Celik, Hasan |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

1

page 1 of 2

Europäisches
Patentamt

European
Patent Office

Office européen
des brevets

# EUROPEAN SEARCH REPORT

Application Number

EP 22 30 6072

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | ZHANG ZIHENG ET AL: "PPGNet: Learning Point-Pair Graph for Line Segment Detection", 2019 IEEE/CVF CONFERENCE ON COMPUTER VISION AND PATTERN RECOGNITION (CVPR), IEEE, 15 June 2019 (2019-06-15), pages 7098-7107, XP033687359, DOI: 10.1109/CVPR.2019.00727 [retrieved on 2020-01-08] * page 7099 * | 8-10 | |

TECHNICAL FIELDS
SEARCHED      (IPC)

The present search report has been drawn up for all claims

| Place of search | Date of completion of the search | Examiner |
|---|---|---|
| Munich | 8 February 2023 | Celik, Hasan |

EPO FORM 1503 03.82 (P04C01)

**EP 4 310 779 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **RUMELHART et al.** *Learning internal representations by error backpropagation,* 1986
- **NAN XUE ; TIANFU WU ; SONG BAI ; FUDONG WANG ; GUI-SONG XIA1 ; LIANGPEI ZHANG ; PHILIP H.S. TORR.** Holistically-Attracted Wireframe Parsing. *CVPR,* 2020
- **YICHAO ZHOU ; HAOZHI QI ; YI MA.** End-to-End Wireframe Parsing. *ICCV,* 2019
- **MARTIN A. FISCHLER ; ROBERT C. BOLLES.** Random Sample Consensus: A Paradigm for Model Fitting with Applications to Image Analysis and Automated Cartography. *SRI International,* 1981
- **RAHUL RAGURAM ; JAN-MICHAEL FRAHM ; MARC POLLEFEYS.** A Comparative Analysis of RANSACTechniques Leading to Adaptive Real-TimeRandom Sample Consensus. *ECCV,* 2008
- **JAMES TANTON.** *Computing Areas,* 2014